# EUROPEAN PATENT APPLICATION

(11) **EP 1 806 768 A1**
(43) Date of publication of application: **11.07.2007**
(21) Application number: 05767020.0
(22) Date of filing: 27.07.2005
(51) Int. Cl.: H01L 21/02, H01L 27/12, H01L 29/786, H01L 21/762, H01L 21/76, H01L 21/265

(54) **PROCESS FOR PRODUCING SEMICONDUCTOR SUBSTRATE AND SEMICONDUCTOR SUBSTRATE**

(30) Priority: 30.07.2004 JP 2004223460
(71) Applicant: Komatsu Denshi Kinzoku Kabushiki Kaisha, Hiratsukashi, Kanagawa 254-0014 (JP)
(72) Inventor: IMAI, Masato, KOMATSU DENSHI KINZOKU K.K., Hiratsuka-shi, Kanagawa 2540014 (JP); MIYAMURA, Yoshiji, KOMATSU DENSHI KINZOKU K.K., Hiratsuka-shi, Kanagawa 2540014 (JP)
(74) Representative: Fiener, Josef
(86) International application number: PCT/JP2005/013744
(87) International publication number: WO 2006/011517

(57) **Abstract**

A process for producing a semiconductor substrate, in which high-quality SGOI substrate (10) effecting a lowering of dislocation density of silicon germanium Si_{1-y}Ge_{y} layer (SGOI layer) disposed on an embedded oxide film to thereby inhibit defect occurrence can be produced according to the SIMOX method; and a relevant semiconductor substrate. The SGOI substrate is produced by regulating the elemental ratio (x) of germanium Ge in a silicon germanium Si₁₋ₓGeₓ layer prior to the treatment according to the SIMOX method to one of ≦ given value such that the dislocation density of silicon germanium Si_{1-y}Ge_{y} layer after the treatment according to the SIMOX method is ≦ given level. Preferably, the dislocation density of silicon germanium Si_{1-y}Ge_{y} layer (SGOI layer) after the treatment according to the SIMOX method is regulated to an elemental ratio (x) of 106 cm⁻² or below. Further, preferably, the elemental ratio (x) of germanium Ge in a silicon germanium Si₁₋ₓGeₓ layer prior to the treatment according to the SIMOX method is adjusted to 0.05(5%) or below.

## Description

### TECHNICAL FIELD

The present invention relates to a production method for a semiconductor substrate for a strained SOI wafer and a semiconductor substrate produced according to this production method.

### BACKGROUND ART

In recent years strained SOI (silicon on insulator) wafers have gathered attention as semiconductor wafers that combine speed improvements and lower electricity consumption in ULSI devices. Strained SOI wafers are produced by causing epitaxial growth of a silicon Si layer on a SGOI (silicon germanium on insulator) substrate. SGOI substrates are produced by forming a silicon germanium SiGe layer on an embedded oxide film.

Thus producing a high quality SGOI substrate with a low dislocation density is linked to improving the quality of strained SOI wafers.

The conventional production methods of SGOI are:
1) a bonding method, and
2) the SIMOX method.

The bonding method mentioned first above is one in which bulk strained Si [layers] produced according to the gradient method are bonded together to be used as a wafer, and has the problems of having a complex, high cost production method, and of the SiGe layer having a high dislocation density.

In contrast the SIMOX method mentioned second above has a comparatively simple production method, realizing reduced costs.

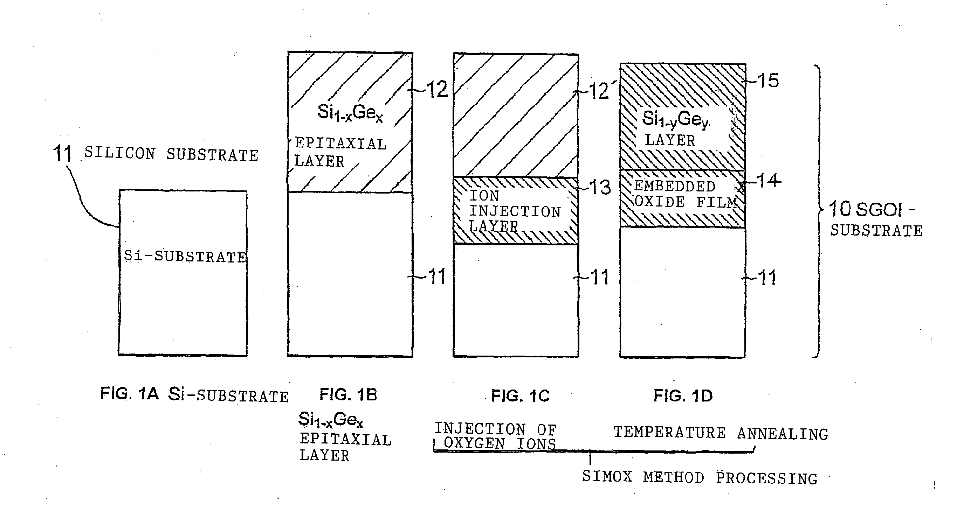

The SIMOX method will be explained using Figs. 1A through 1D.

First a silicon substrate 11 is prepared (Fig. 1A), and a silicon germanium Si₁₋ₓGeₓ layer 12 with a germanium Ge composition rate (x), is formed through epitaxial growth on this silicon substrate 11 (Fig. 1B).

Next this silicon germanium Si₁₋ₓGeₓ layer is processed according to the SIMOX method shown in Figs. 1C and D, and a resulting SGOI substrate 10 is produced with a silicon germanium Si_{1-y}Ge_{y} layer 15 formed on an embedded oxide film 14.

More specifically, a predetermined dose amount (a number of ions per unit of,area) of oxygen ions O⁺ are injected by an injection device into the silicon substrate 11, on which the silicon germanium Si₁₋ₓGeₓ layer 12 has been grown. Through this process, an ion injection layer 13, with the predetermined dose amount of oxygen ions O⁺, is formed between the silicon substrate 11 and a silicon germanium Si₁₋ₓGeₓ layer 12 (Fig. 1C).

Next high temperature annealing is performed on the substrate. Through this process the injected oxygen ions O⁺ react with the silicon Si, forming SiO₂, and the ion injection layer 13 changes to an embedded oxide film 14, which lies beneath the silicon germanium Si₁₋ₓGeₓ layer 12 Through the high temperature annealing, the silicon germanium Si₁₋ₓGeₓ layer 12 prior to the high temperature annealing process has its layer thickness thinned while its composition ratio is changed, in that the germanium composition ratio (x) prior to the injection of oxygen ions changes so that a different silicon germanium Si_{1-y}Ge_{y} layer 15 having a germanium composition ratio (y) is formed. This happens due to the diffusion of the germanium Ge, which is comprised in the layer 12 , in the bulk; and due to the forming of the oxide film on the surface due to a reaction of the silicon Si, which is comprised in the layer 12 , and oxygen in the ambient air. This silicon germanium Si_{1-y}Ge_{y} layer 15 is called an SGOI (silicon germanium on insulator) layer (Fig. 1D).

The SGOI substrate 10 is thus completed according to the process described above.

The germanium Ge concentration of the silicon germanium Si_{1-y}Ge_{y} layer (SGOI layer) 15 on the SGOI substrate 10 produced in this manner must be a high concentration that is greater than or equal to a fixed level in order to satisfy the performance requirements (high speed performance) of the semiconductor device. Furthermore, the germanium Ge diffuses in the bulk at the time of the high temperature annealing, which is after the injection of the oxygen ions (Fig. 1D). Thus it has been a basic technical assumption that the silicon germanium Si₁₋ₓGeₓ layer 12 is formed in advance through epitaxial growth with a high concentration of Ge deposited, before the injection of the oxygen ions. The basic technical assumption was that the composition ratio (x) of the germanium Ge in the silicon germanium Si₁₋ₓGeₓ layer 12 should be a high concentration amount such as 0.1 (10%) or 0.2 (20%).

In patent document 1 (Japanese Unexamined Patent Application Publication No. 2001-148473) technology is disclosed in which a silicon germanium layer is formed on an embedded oxide film. Technology is also disclosed in patent document 1 in which a protective layer is formed by hydrogen termination processing on the surface of the silicon germanium layer in order to prevent oxidation and contamination of the surface of the silicon germanium layer. A description is given of setting the composition ratio of the germanium Ge in the silicon germanium layer to 0, 10, 20, and 30% according to the relationship of the composition ratio to a minimum concentration of a hydrofluoric acid solution required for the hydrogen termination processing. Also, a description is given in this patent document 1 of setting the composition ratio of the germanium Ge in the silicon germanium layer to 20% before the forming of the embedded oxide film. Patent document 1: Japanese Patent Application Laid-open No. 2001-148473

### DISCLOSURE OF THE INVENTION

### Problem to be Solved by the Invention

Dislocation cannot be avoided in the silicon germanium Si_{1-y}Ge_{y} layer (SGOI layer) 15 lying on the embedded oxide film 14 when the SGOI substrate 10 is produced according to the SIMOX method, using preexisting production methods.

The present invention is one that solves the problem by using the SIMOX method to produce a high quality semiconductor substrate (SGOI substrate 10) that lowers the dislocation density in the silicon germanium Si_{1-y}Ge_{y} layer (SGOI layer) 15 lying on the embedded oxide film 14.

### Means to Solve the Problem

The first invention is [a method] for producing a semiconductor substrate by forming a silicon germanium Si₁₋ₓGeₓ layer ((x) being a composition ratio of the germanium Ge) on a silicon substrate, and then, through a SIMOX method processing, forming a silicon germanium Si_{1-y}Ge_{y} layer ((y) being a composition ratio of the germanium Ge) on an embedded oxide film,
characterized in that the semiconductor substrate is produced by adjusting the composition ratio (x) of the germanium Ge in the silicon germanium layer Si₁₋ₓGeₓ prior to the SIMOX method processing to a composition ratio of a predetermined ratio or less in which a dislocation density in the silicon germanium layer Si_{1-y}Ge_{y} after the SIMOX method processing becomes a predetermined level or less.

The second invention is characterized in that, in the first invention, the composition ratio (x) is adjusted so that the dislocation density in the silicon germanium layer Si_{1-y}Ge_{y} after the SIMOX method processing becomes 10⁶ cm⁻² or less.

The third invention is characterized in that, in the first invention or in the second invention, the composition ratio (x) of the germanium Ge in the silicon germanium layer Si₁₋ₓGeₓ prior to the SIMOX method processing is 0.05 (5%) or less.

The fourth invention is a semiconductor substrate produced by forming a silicon germanium Si₁₋ₓGeₓ layer ((x) being a composition ratio of the germanium Ge) on a silicon substrate, and then, through a SIMOX method processing, forming a silicon germanium Si_{1-y}Ge_{y} layer ((y) being a composition ratio of the germanium Ge) on an embedded oxide film,
characterized in that the semiconductor substrate is produced by adjusting the composition ratio (x) of the germanium Ge in the silicon germanium layer Si₁₋ₓGeₓ prior to the SIMOX method processing to a composition ratio (x) in which a dislocation density in the silicon germanium layer Si_{1-y}Ge_{y} after the SIMOX method processing becomes 10⁶ cm⁻² or less, whereby the dislocation density in the silicon germanium layer Si_{1-y}Ge_{y} of the produced semiconductor substrate is 10⁶ cm⁻² or less.

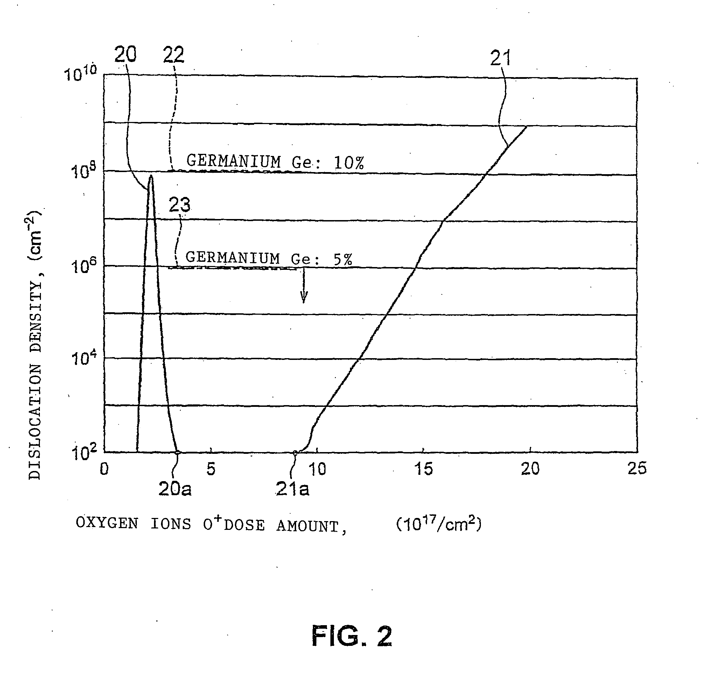

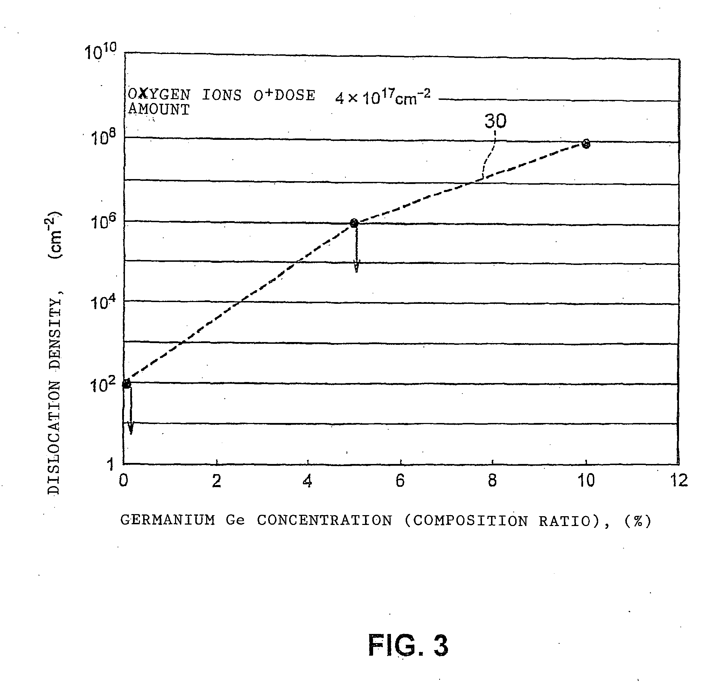

In the present invention the dislocation density in the silicon germanium Si_{1-y}Ge_{y} layer 15 after the SIMOX method processing is influenced by the composition ratio (x) of the germanium Ge in the silicon germanium Si₁₋ₓGeₓ layer 12 prior to the SIMOX method processing (refer to Fig. 2). The present invention was obtained from the observation that as the composition ratio (x) of the germanium Ge is lowered the dislocation density is reduced (refer to Fig. 3). Here, when the prior art described in patent document 1 is compared with the present invention, the composition ratio of the germanium Ge is set relative to the minimum concentration of the hydrofluoric acid solution required for the hydrogen termination processing in order to prevent oxidation and contamination of the surface of the silicon germanium layer. Patent document 1 does not suggest in the least the observation of the present invention of setting the composition ratio of the germanium Ge relative to the size of the displacement density in order to lower the displacement density. Also, the conventional technological assumption of setting the composition ratio of the germanium Ge in the silicon germanium layer to 20% prior to the formation of the embedded oxide film is described in patent document 1, however, this description does not suggest in the least the observation of the present invention, which is contrary to the conventional technical assumptions, in that the composition ratio of the germanium Ge in the silicon germanium layer is lowered prior to the formation of the embedded oxide film in order to reduce the dislocation density.

According to the first invention, the composition ratio (x) of the germanium Ge of the silicon germanium Si₁₋ₓGeₓ layer 12 prior to the SIMOX method processing is adjusted to a composition ratio of a predetermined value or less in which the dislocation density in the silicon germanium Si_{1-y}Ge_{y} layer 15 after the SIMOX method processing becomes a predetermined level or less, producing an SGOI substrate. Hence the dislocation density in the silicon germanium Si_{1-y}Ge_{y} layer (SGOI layer) 15 is sufficiently lowered and a high quality SGOI substrate 10 is obtained.

Preferably the composition ratio (x) is adjusted to a composition ratio in which the dislocation density in the silicon germanium Si_{1-y}Ge_{y} layer (SGOI layer) 15 after the SIMOX method processing becomes 10⁶ cm⁻² or less (refer to Fig. 3; second invention).

Also it is preferable that the composition ratio (x) of the germanium Ge in the silicon germanium Si₁₋ₓGeₓ layer 12 prior to the SIMOX method processing be set to 0.05 (5%) or less, thus it becomes possible for the dislocation density to be sufficiently lowered (to a limit for a measured value or less) in the region of the dose window, considered to be the region in which the dislocation density is lowered in the SOI substrate (refer to Fig. 2). The dislocation can be sufficiently suppressed in at least the dose window region (third invention).

The fourth invention is the SGOI substrate produced according to the production method in the first invention. The characteristic of this substrate is that the dislocation density in the silicon germanium Si_{1-y}Ge_{y} layer (SGOI layer) 15 is 10⁶ cm⁻² or less due to it being produced according to the production method in the first invention.

### BEST MODE FOR CARRYING OUT THE INVENTION

An embodiment of a SGOI substrate production method relating to the present invention will be explained below in reference to the drawings.

First, the production process of the embodiment of the present invention will be explained.

Figs. 1A, B, C, and D show the production process of the embodiment and are conceptual cross section drawings of a substrate.

As shown in Figs. 1A, B, C, and D a silicon substrate 11 is prepared (Fig. 1A), and a silicon germanium Si₁₋ₓGeₓ layer 12 with a composition ratio (x) of germanium Ge is formed on the silicon substrate 11 through epitaxial growth (Fig. 1B).

Next, after the silicon germanium Si₁₋ₓGeₓ layer 12 is processed according to the SIMOX method shown in Figs. 1C and D, a SGOI substrate 10 is produced by forming a silicon germanium Si_{1-y}Ge_{y} layer 15 on an embedded oxide film 14.

More specifically, a predetermined dose amount (a number of ions per unit of area) of oxygen ions O⁺ are injected by an injection device into the silicon substrate 11, on which the silicon germanium Si₁₋ₓGeₓ layer 12 has been grown. Through this process, an ion injection layer 13, with the predetermined dose amount of oxygen ions O⁺, is formed between the silicon substrate 11 and a silicon germanium Si₁₋ₓGeₓ layer 12 Also, in conjunction with the formation of the ion injection layer 13, the silicon germanium Si₁₋ₓGeₓ layer 12 changes into the silicon germanium Si₁₋ₓGeₓ layer 12 (Fig. 1C).

Next high temperature annealing is performed on the substrate. Through this process the injected oxygen ions O⁺ react with the silicon Si, forming SiO₂, and the ion injection layer 13 changes to the embedded oxide film 14 beneath the silicon germanium Si₁₋ₓGeₓ layer 12 . Through the high temperature annealing, the silicon germanium Si₁₋ₓGeₓ layer 12 prior to the high temperature annealing process has its layer thickness thinned while its composition ratio is changed, in that the germanium composition ratio (x) prior to the injection of oxygen ions changes so that a different silicon germanium Si_{1-y}Ge_{y} layer 15 having a germanium composition ratio (y) is formed. This happens due to the diffusion of the germanium Ge, which is comprised in the layer 12', in the bulk, and due to the forming of the oxide film on the surface due to a reaction of the silicon Si, which is comprised in the layer 12', and oxygen in the ambient air. This silicon germanium Si_{1-y}Ge_{y} layer 15 is called an SGOI (silicon germanium on insulator) layer (Fig. 1D).

The SGOI substrate 10 is thus completed according to the process described above.

Next a graph showing an observation of the present invention will be explained.

Fig. 2 is a graph showing the influence of the composition ratio (x) of the germanium Ge in the silicon germanium Si₁₋ₓGeₓ layer 12 prior to SIMOX method processing on the dislocation density in the silicon germanium Si_{1-y}Ge_{y} layer 15 after the SIMOX method processing.

The horizontal axis of Fig. 2 is the dose amount (10¹⁷/cm²) of oxygen ions O⁺ ion-injected at the oxygen ion injection process of Fig. 1C, and the vertical axis is the dislocation density (cm⁻²) in the silicon germanium Si_{1-y}Ge_{y} layer (SGOI layer) 15 after the SIMOX method processing.

Characteristic lines 20 and 21, shown by solid lines in Fig. 2, show the relationship between the dose amount of the oxygen ions O⁺ and the dislocation density in the silicon Si layer on the embedded oxide film at the time of production of the SOI substrate.

The characteristic line 20 shows that, at the time in which the silicon Si layer is formed on the embedded oxide film (the time in which the SOI substrate is produced), the peak value of the dislocation density exists in a region in which the dose amount of the oxygen ions O⁺ is low. When the dose amount of the oxygen ions O⁺ increases, the dislocation density becomes 10² (cm⁻²) or less at a value 20a or more of the dose amount of the oxygen ions O⁺. When the dose amount of the oxygen ions O⁺ is further increased, as shown by the characteristic line 21, the dislocation density climbs to 10² (cm⁻²) or more at a value 21a of the dose amount of the oxygen ions O⁺, and the dislocation density continues to rise in conjunction with an increase in the dose amount of the oxygen ions O⁺.

In this manner, it has become known that in cases of a SOI substrate, a region (10² (cm⁻²) or less) in which the dislocation density is at a sufficiently low level, more specifically a region called "the dose window", exists in a specified region of the dose amount of the oxygen ions O⁺ (from 20a to 21a).

At this point an experiment was performed to determine whether a similar dose window region also exists in a SGOI substrate. The result was that a discovery was made in which a dose window was formed when the composition ratio (x) of the germanium Ge in the silicon germanium Si₁₋ₓGeₓ layer 12 was lowered prior to the SIMOX method processing.

A characteristic line 22, shown by a broken line in Fig. 2, and a characteristic line 23, shown by a one dot chain line in Fig. 2, show the relationship between the dose amount of the oxygen ions O⁺ and the dislocation density in the silicon germanium Si_{1-y}Ge_{y} layer (SGOI layer) 15 lying on the embedded oxide film 14 at the time of production of the SGOI substrate. The characteristic line 22 shows a case in which the composition ratio (x) of the germanium Ge is set to 10%, and the characteristic line 23 shows a case in which the composition ratio (x) of the germanium Ge is set to 5%.

At the time in which the silicon germanium Si_{1-y}Ge_{y} layer (SGOI layer) 15 is formed on the embedded oxide film 14 (at the time the SGOI substrate 10 is produced), as shown by the characteristic line 22, the dislocation density becomes a high level of 10⁸ (cm⁻²) in the specified region of the dose amount of the oxygen ions O⁺ (from 20a to 21a) when the composition ratio (x) of the germanium Ge is set to 10%, however, as shown by the characteristic line 23, the dislocation density falls to a low level of 10⁶ (cm⁻²) in the specified region of the dose amount of the oxygen ions O⁺ (from 20a to 21 a) when the composition ratio (x) of the germanium Ge is set to 5%.

In this manner it is possible to sufficiently lower the dislocation density in the region of the dose window (from 20a to 21a), considered to be the region in which the dislocation density is lowered in the SOI substrate, by setting the composition ratio (x) of the germanium Ge in the silicon germanium Si₁₋ₓGeₓ layer 12 to 0.05 (5%) or less prior to the SIMOX method processing, and the dislocation can be sufficiently suppressed to at least this dose window region (from 20a to 21a).

Fig. 3 also shows that the dislocation density is reduced as the composition ratio (x) of the germanium Ge is lowered.

The horizontal axis of Fig. 3 is the concentration (composition ratio) (x) (%) of the germanium Ge in the silicon germanium Si₁₋ₓGeₓ layer 12 prior to the SIMOX method processing, and the vertical axis is the dislocation density (cm⁻²) in the silicon germanium Si_{1-y}Ge_{y} layer (SGOI layer) 15 after the SIMOX method processing. A characteristic line 30 shown by the broken line shows the correlation between the germanium concentration (composition ratio) (x), when the dose amount of the oxygen ions O⁺ is 4× 10¹⁷ cm², and the dislocation density. It is desirable to set the dislocation density in the silicon germanium Si_{1-y}Ge_{y} layer (SGOI layer) 15 to 10⁶ cm⁻² or less in order to ensure that the finished product has no quality defects. Thus it is preferable to adjust the composition ratio (x) of the germanium Ge in the silicon germanium Si₁₋ₓGeₓ layer 12 according to the characteristic line 30 shown in Fig. 3 prior to the SIMOX method processing, so that the dislocation density becomes 10⁶ cm⁻² or less.

According to the present embodiment on the basis of the observations described above, the composition ratio (x) of the germanium Ge of the silicon germanium Si₁₋ₓGeₓ layer 12 prior to the SIMOX method processing is adjusted to a composition ratio of a predetermined value or less in which the dislocation density in the silicon germanium Si_{1-y}Ge_{y} layer 15 after the SIMOX method processing becomes a predetermined level or less, producing an SGOI substrate 10. Thus the dislocation density in the silicon germanium Si_{1-y}Ge_{y} layer (SGOI layer) 15 is sufficiently lowered and a high quality SGOI substrate 10 is obtained.

Preferably the composition ratio (x) is adjusted to a composition ratio in which the dislocation density in the silicon germanium Si_{1-y}Ge_{y} layer (SGOI layer) 15 after the SIMOX method processing becomes 10⁶ cm⁻² or less.

Also it is preferable that the composition ratio (x) of the germanium Ge in the silicon germanium Si₁₋ₓGeₓ layer 12 prior to the SIMOX method processing be set to 0.05 (5%) or less. Thus it becomes possible for the dislocation density in the SOI substrate to be sufficiently lowered (to a limit for a measured value or less) in the region of the dose window, considered to be the region in which the dislocation density is lowered in the SOI substrate.

### (Embodiment)

Next, one example of the process conditions will be given.

In an experiment, the concentration (composition ratio) (x) (%) of the germanium Ge of the silicon germanium Si₁₋ₓGeₓ layer 12 shown in Fig. 1B was adjusted to 0, 5, and 10%. The SGOI substrate 10 was produced using each percentage with process conditions described below. The film thickness of the epitaxial growth layer 12 was set to 400 nm.

The acceleration voltage was set to 180 keV and the substrate temperature was set to 550° C, in the oxygen ion injection process shown in Fig. 1C. The dose amount of the injected oxygen ions O⁺ was 4X 10¹⁷/cm².

The temperature annealing shown in Fig. 1D was performed at 1350° for four hours.

As a result a SGOI substrate 10 was obtained formed from a silicon germanium Si_{1-y}Ge_{y} layer (SGOI layer) 15, having a thickness of 320 nm, lying on an embedded oxide film 14, having a thickness of 85 nm.

The germanium Ge concentrations (composition ratios) (y) (%) after the SIMOX method processing were 0, 2.7, and 5.4%, corresponding respectively to the germanium Ge concentrations (composition ratios) (x) (%) before the SIMOX method processing of 0, 5, and 10%. The defect densities were respectively 10³ cm⁻² or less, 10⁶ cm⁻² or less, and 10⁸ cm⁻² or less.

### BRIEF DESCRIPTION OF THE DRAWINGS

Figs. 1A, B, C, and D are drawings showing the production process of the SGOI substrate according to the SIMOX method.
Fig. 2 is a graph showing the relationship of the dislocation density to the oxygen ion dose and the germanium Ge concentration (composition ratio).
Fig. 3 is a graph showing the relationship of the dislocation density to the germanium Ge concentration (composition ratio).

## Claims

1. A method for producing a semiconductor substrate by forming a silicon germanium Si₁₋ₓGeₓ layer ((x) being a composition ratio of the germanium Ge) on a silicon substrate, and then, through a SIMOX method processing, forming a silicon germanium Si_{1-y}Ge_{y} layer ((y) being a composition ratio of the germanium Ge) on an embedded oxide film,
**characterized in that** a SGOI substrate is produced by adjusting the composition ratio (x) of the germanium Ge in the silicon germanium layer Si₁₋ₓGeₓ prior to the SIMOX method processing to a composition ratio of a predetermined ratio or less in which a dislocation density in the silicon germanium layer Si_{1-y}Ge_{y} after the SIMOX method processing becomes a predetermined level or less.

2. The method for producing a semiconductor substrate according to claim 1, **characterized in that** the composition ratio (x) is adjusted so that the dislocation density in the silicon germanium layer Si_{1-y}Ge_{y} after the SIMOX method processing becomes 10⁶ cm⁻² or less.

3. The method for producing a semiconductor substrate according to claim 1 or claim 2, **characterized in that** the composition ratio (x) of the germanium Ge in the silicon germanium layer Si₁₋ₓGeₓ prior to the SIMOX method processing is 0.05 (5%) or less.

4. A semiconductor substrate produced by forming a silicon germanium Si₁₋ₓGeₓ layer ((x) being a composition ratio of the germanium Ge) on a silicon substrate, and then, through a SIMOX method processing, forming a silicon germanium Si_{1-y}Ge_{y} layer ((y) being a composition ratio of the germanium Ge) on an embedded oxide film,
**characterized in that** the semiconductor substrate is produced by adjusting the composition ratio (x) of the germanium Ge in the silicon germanium layer Si₁₋ₓGeₓ prior to the SIMOX method processing to a composition ratio (x) in which a dislocation density in the silicon germanium layer Si_{1-y}Ge_{y} after the SIMOX method processing becomes 10⁶ cm⁻² or less, whereby the dislocation density in the silicon germanium layer Si_{1-y}Ge_{y} of the produced semiconductor substrate is 10⁶ cm⁻² or less.
